# EUROPEAN PATENT APPLICATION

(11) **EP 2 555 253 A1**
(43) Date of publication of application: **06.02.2013**
(21) Application number: 11762815.6
(22) Date of filing: 28.03.2011
(51) Int. Cl.: H01L 31/042

(54) **WAVELENGTH-CONVERTING SOLAR CELL SEALING SHEET, AND SOLAR CELL MODULE**

(30) Priority: 29.03.2010 JP 2010076313
(71) Applicant: Hitachi Chemical Company, Ltd., Tokyo 163-0449 (JP); Mitsubishi Electric Corporation, Tokyo 100-8310 (JP)
(72) Inventor: SAWAKI, Taku, Tsukuba-shi Ibaraki 300-4247 (JP); OKANIWA, Kaoru, Tsukuba-shi Ibaraki 300-4247 (JP); YAMASHITA, Takeshi, Tsukuba-shi Ibaraki 300-4247 (JP); MORIKAWA, Hiroaki, Tokyo 100-8310 (JP)
(74) Representative: HOFFMANN EITLE
(86) International application number: PCT/JP2011/057724
(87) International publication number: WO 2011/122591

(57) **Abstract**

A wavelength conversion type photovoltaic cell sealing sheet of the present invention includes a dispersion medium resin, and a fluorescent material having an absorption wavelength peak at from 300 to 450 nm, wherein a content of an ultraviolet absorber other than the fluorescent substance is 0.15 parts by mass or less with respect to 100 parts by mass of the dispersion medium resin. Furthermore, a photovoltaic cell module of the present invention has a photovoltaic cell and the wavelength conversion type photovoltaic cell sealing sheet.

## Description

### Technical Field

The present invention relates to a wavelength conversion type photovoltaic cell sealing sheet and a photovoltaic cell module using the same. More particularly, the present invention relates to a wavelength conversion type photovoltaic cell sealing sheet which contains no ultraviolet absorber other than a fluorescent substance; and a photovoltaic cell module using the same.

### Background Art

Silicon crystal-based photovoltaic cells generally have a low sensitivity to a light in the ultraviolet region. Therefore, it has been attempted to increase a light in a high sensitive wavelength region and improve the conversion efficiency by converting a light in the ultraviolet region to a light having a wavelength in the visible or near-infrared region. So far, in Japanese Patent Application Laid-Open (JP-A) No. 2003-243682, JP 2003-218379A, Japanese Patent Publication (Kokai) No. H08-004147, JP 2001-094128A, JP 2001-352091A and the like, there have been proposed a number of techniques for providing on the light-receiving surface side of a photovoltaic cell a layer in which a fluorescent substance is used to emit a light in a wavelength region largely contributing to power generation by converting the wavelength of a light in the ultraviolet or infrared region having small contribution to power generation in the solar light spectrum.

Further, JP 2006-303033A proposes a method for incorporating a rare earth complex, which is a fluorescent substance, into a sealing material.
Moreover, conventionally, ethylene-vinyl acetate copolymers that are imparted with thermosetting property have been widely used as a transparent sealant for photovoltaic cells (see, for example, JP 2005-126708A and JP 2008-159856A).

As such sealant (also referred to as "filler"), a resin having an ethylene-vinyl acetate copolymer as a principal component is usually employed and the sealant contains an ultraviolet absorber.

This ultraviolet absorber absorbs harmful ultraviolet radiation in the irradiation light to convert it into harmless heat energy within a molecule, thereby preventing a photodegradation-initiating active species in a polymer from becoming excited by ultraviolet radiation.

Examples of commonly used ultraviolet absorbers include those of benzophenone-based, benzotriazole-based, triazine-based, salicylic acid-based and cyanoacrylate-based; and in particular, benzophenone-based ultraviolet absorbers are widely used since they are capable of highly preventing the photodegradation of ethylene-vinyl acetate copolymers.

### DISCLOSURE OF INVENTION

### Problems to be solved by the present invention

However, transparent sealing films for photovoltaic cells have a low power generation efficiency due to the inclusion of an ultraviolet absorber. This is because the absorption spectrum of the ultraviolet absorber slightly overlaps with the sensitive spectrum of the photovoltaic cell. Yet, there has been a problem that a sealing film containing no ultraviolet absorber has a low anti-weatherability and is thus not practical.

The present invention was made in view of the above-described problems and an object of the present invention is to provide a wavelength conversion type photovoltaic cell sealing sheet which improves the power generation efficiency without impairing the anti-weatherability.

### Means for solving problems

In order to solve the above-described problems, the present inventors intensively studied and found that, by allowing a wavelength conversion type photovoltaic cell sealing sheet to contain a dispersion medium resin and a fluorescent substance having an absorption wavelength peak at from 300 nm to 450 nm and by controlling the content of an ultraviolet absorber other than the fluorescent substance at 0.15 parts by mass or less with respect to 100 parts by mass of the dispersion medium resin, the power generation efficiency is improved and the above-described fluorescent substance itself functions as an ultraviolet absorber, thereby completing the present invention.

The above-described wavelength conversion type photovoltaic cell sealing sheet not only converts, by a fluorescent substance contained therein, a light of the ultraviolet region in the incoming sunlight, which is of a small contribution to photovoltaic power generation, to a light having a wavelength contributing to power generation, but also absorbs ultraviolet light to prevent the photodegradation-initiating active species of a polymer contained in the sealing sheet from becoming excited; therefore, Both a high power generation efficiency and anti-weatherability can be attained.
Accordingly, the wavelength conversion type photovoltaic cell sealing sheet according to the present invention can improve the power generation efficiency and prevent a reduction in the anti-weatherability as compared to conventional wavelength conversion type photovoltaic cell sealing sheets.
That is, the present invention is as follows.

The wavelength conversion type photovoltaic cell sealing sheet according to the present invention contains a dispersion medium resin and a fluorescent material having an absorption wavelength peak at from 300 to 450 nm and has a content of an ultraviolet absorber other than the fluorescent substance of 0.15 parts by mass or less with respect to 100 parts by mass of the dispersion medium resin. The above-described fluorescent substance is preferably a europium complex.

Further, the photovoltaic cell module according to the present invention has a photovoltaic cell and the above-described wavelength conversion type photovoltaic cell sealing sheet provided on a light-receiving surface side of the photovoltaic cell.

### EFFECTS OF INVENTION

According to the present invention, a wavelength conversion type photovoltaic cell sealing sheet which improves the power generation efficiency without impairing the anti-weatherability and a photovoltaic cell module are provided.

### BRIEF DESCRIPTION OF DRAWINGS

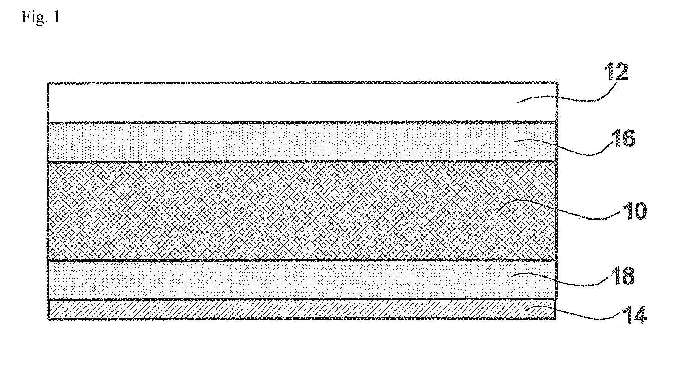

[Fig. 1] Fig. 1 is a schematic cross-sectional view showing an example of photovoltaic cell module.

### Best Mode for Carrying Out the Invention

Embodiments of the present invention will now be described in detail. It is noted here that those numerical ranges that are stated herein with "to" indicate a range which includes the numerical values stated before and after "to" as the minimum and maximum values, respectively.

### <Wavelength conversion type photovoltaic cell sealing sheet>

The wavelength conversion type photovoltaic cell sealing sheet according to the present invention is used on the light-receiving surface side of a photovoltaic cell module. The wavelength conversion type photovoltaic cell sealing sheet according to the present invention contains a dispersion medium resin and a fluorescent substance having an absorption wavelength peak at from 300 to 450 nm and has a content of an ultraviolet absorber other than the fluorescent substance 1 of 0.15 parts by mass or less with respect to 100 parts by mass of the dispersion medium resin.

### (Fluorescent substance)

The fluorescent substance used in the present invention has an absorption wavelength peak at from 300 to 450 nm. From the standpoint of effectively preventing a photodegradation-initiating active species of a polymer contained in the wavelength conversion type photovoltaic cell sealing sheet from becoming excited, the fluorescent substance used in the present invention is one which has an absorption wavelength peak at from 300 to 450 nm.
The fluorescent substance used in the present invention may be used individually, or two or more thereof may be used in combination.

Examples of fluorescent substance suitably used in the present invention include organic complexes of rare earth metals. Thereamong, europium complexes or samarium complexes are preferred, and europium complexes are more preferred.
By using a europium complex as the fluorescent substance, a photovoltaic cell module having a high power generation efficiency may be realized. A europium complex converts a light in the ultraviolet region to a light in the red wavelength region at a high wavelength conversion efficiency and the thus converted light contributes to the power generation in a photovoltaic cell.

In addition to a central element, europium (Eu), a europium complex requires a molecule which serves as a ligand; however, in the present invention, the type of the ligand is not restricted and the ligand may be any molecule as long as it forms a complex with europium.

As a fluorescent substance composed of such europium complex, for example, a rare earth complex such as Eu(TTA)₃phen may be employed. As for the production method of Eu(TTA)₃Phen, for example, the one disclosed in Masaya Mitsuishi, Shinji Kikuchi, Tokuji Miyashita, Yutaka Amano, J. Mater. Chem. 2003, 13, 2875-2879 may be referred.

In the present invention, the ligand of such complex is not restricted; however, as a neutral ligand, carboxylic acids, nitrogen-containing organic compounds, nitrogen-containing aromatic heterocyclic compounds, β-diketones or phosphine oxides are preferred.
As the ligand of a rare earth complex, a β-diketone represented by the formula : R¹COCHR²COR³ (wherein, R¹ represents an aryl group, an alkyl group, a cycloalkyl group, a cycloalkylalkyl group, an aralkyl group or a substitution product thereof; R² represents a hydrogen atom, an alkyl group, a cycloalkyl group, a cycloalkylalkyl group, an aralkyl group or an aryl group; and R³ represents an aryl group, an alkyl group, a cycloalkyl group, a cycloalkylalkyl group, an aralkyl group or a substitution product thereof) may also be contained.

Specific examples of the β-diketone include acetylacetone, perfluoroacetylacetone, benzoyl-2-furanoylmethane, 1,3-bis(3-pyridyl)-1,3-propanedione, benzoyltrifluoroacetone, benzoylacetone, 5-chlorosulfonyl-2-thenoyltrifluoroacetone, di(4-bromo)benzoylmethane, dibenzoylmethane, d,d-dicampholylmethane, 1,3-dicyano-1,3-propanedione, p-di(4,4,5,5,6,6,6-heptafluoro-1,3-hexanedinoyl)benzene, 4,4'-dimethoxydibenzoylmethane, 2,6-dimethyl-3,5-heptanedione, dinaphthoylmethane, dipivaloylmethane, di(perfluoro-2-propoxypropionyl)methane, 1,3-di(2-thienyl)-1,3-propanedione, 3-(trifluoroacetyl)-d-camphor, 6,6,6-trifluoro-2,2-dimethyl-3,5-hexanedione, 1,1,1,2,2,6,6,7,7,7-decafluoro-3,5-heptanedione, 6,6,7,7,8,8,8-heptafluoro-2,2-dimethyl-3,5-octanedione, 2-furyltrifluoroacetone, hexafluoroacetylacetone, 3-(heptafluorobutyryl)-d-camphor, 4,4,5,5,6,6,6-heptafluoro-1-(2-thienyl)-1,3-hexanedione, 4-methoxydibenzoylmethane, 4-methoxybenzoyl-2-furanoylmethane, 6-methyl-2,4-heptanedione, 2-naphthoyltrifluoroacetone, 2-(2-pyridyl)benzimidazole, 5,6-dihydroxy-10-phenanthroline, 1-phenyl-3-methyl-4-benzoyl-5-pyrazole, 1-phenyl-3-methyl-4-(4-butylbenzoyl)-5-pyrazole, 1-phenyl-3-methyl-4-isobutyryl-5-pyrazole, 1-phenyl-3-methyl-4-trifluoroacetyl-5-pyrazole, 3-(5-phenyl-1,3,4-oxadiazole-2-yl)-2,4-pentanedione, 3-phenyl-2,4-pentanedione, 3-[3',5'-bis(phenylmethoxy)phenyl]-1-(9-phenanthryl)-1-propane-1,3-dione, 5,5-dimethyl-1,1,1-trifluoro-2,4-hexanedione, 1-phenyl-3-(2-thienyl)-1,3-propanedione, 3-(t-butylhydroxymethylene)-d-camphor, 1,1,1-trifluoro-2,4-pentanedione, 1,1,1,2,2,3,3,7,7,8,8,9,9,9-tetradecafluoro-4,6-nonanedione, 2,2,6,6-tetramethyl-3,5-heptanedione, 4,4,4-trifluoro-1-(2-naphthyl)-1,3-butanedione, 1,1,1-trifluoro-5,5-dimethyl-2,4-hexanedione, 2,2,6,6-tetramethyl-3,5-heptanedione, 2,2,6,6-tetramethyl-3,5-octanedione, 2,2,6-trimethyl-3,5-heptanedione, 2,2,7-trimethyl-3,5-octanedione, 4,4,4-trifluoro-1-(thienyl)-1,3-butanedione (TTA), 1,3-diphenyl-1,3-propanedione, benzoylacetone, dibenzoylacetone, diisobutyloylmethane, dibivaloylmethane, 3-methylpentane-2,4-dione, 2,2-dimethylpentane-3,5-dione, 2-methyl-1,3-butanedione, 1,3-butanedione, 3-phenyl-2,4-pentanedione, 1,1,1-trifluoro-2,4-pentanedione, 1,1,1-trifluoro-5,5-dimethyl-2,4-hexanedione, 2,2,6,6-tetramethyl-3,5-heptanedione, 3-methyl-2,4-pentanedione, 2-acetylcyclopentanone, 2-acetylcyclohexanone, 1-heptafluoropropyl-3-t-butyl-1,3-propanedione, 1,3-diphenyl-2-methyl-1,3-propanedione and 1-ethoxy-1,3-butanedione.

Examples of the nitrogen-containing organic compounds, nitrogen-containing aromatic heterocyclic compounds and phosphine oxides that are used as the neutral ligand of rare earth complex include 1,10-phenanthroline, 2-2'-bipyridyl, 2-2'-6,2"-terpyridyl, 4,7-diphenyl-1,10-phenanthroline, 2-(2-pyridyl)benzimidazole, triphenylphosphine oxide, tri-n-butylphosphine oxide, tri-n-octylphosphine oxide and tri-n-butyl phosphate.

It is more preferred that the above-described fluorescent substance be enclosed in a resin particle. The monomer compound constituting the above-described resin particle is not particularly restricted; however, from the standpoint of preventing scattering of light, it is preferably a vinyl compound.
Further, as a method of enclosing the above-described fluorescent substance in a resin particle, any conventionally used method may be employed without any particular restriction. For example, the above-described fluorescent substance may be enclosed in a resin particle by preparing a mixture of the fluorescent material and a monomer compound constituting the resin particle and polymerizing the mixture. Specifically, for example, by preparing a mixture containing the fluorescent substance and a vinyl compound and polymerizing the vinyl compound using a radical polymerization initiator, a fluorescent material for wavelength conversion may be formed as a resin particle in which the fluorescent substance is enclosed. It is noted here that the term "fluorescent material for wavelength conversion" used in the present invention refers to one obtained by polymerization of a vinyl compound containing the fluorescent substance.

In the present invention, the vinyl compound is not particularly restricted as long as it has at least one ethylenically unsaturated bond, and any acrylic monomer, methacrylic monomer, acrylic oligomer, methacrylic oligomer or the like which can be polymerized by a polymerization reaction into a vinyl resin, particularly into an acrylic resin or a methacrylic resin, may be employed without any particular restriction. In the present invention, preferred examples thereof include acrylic monomers and methacrylic monomers.

Examples of the acrylic monomers and methacrylic monomers include acrylic acids, methacrylic acids and alkyl esters thereof, and other vinyl compound capable of copolymerizing therewith may also be used in combination. Also, these may be used individually, or two or more thereof may be used in combination.

Examples of alkyl acrylate and alkyl methacrylate include: unsubstituted alkyl acrylates and unsubstituted alkyl methacrylates such as methyl acrylate, methyl methacrylate, ethyl acrylate, ethyl methacrylate, butyl acrylate, butyl methacrylate, 2-ethylhexyl acrylate and 2-ethylhexyl methacrylate; dicyclopentenyl (meth)acrylates; tetrahydrofurfuryl (meth)acrylates; benzyl (meth)acrylates; compounds obtained by a reaction between a polyhydric alcohol and an α,β-unsaturated carboxylic acid (for example, polyethylene glycol di(meth)acrylates (those having 2 to 14 ethylene groups), trimethylolpropane di(meth)acrylates, trimethylolpropane tri(meth)acrylates, trimethylolpropane ethoxy tri(meth)acrylates, trimethylolpropane propoxy tri(meth)acrylates, tetramethylolmethane tri(meth)acrylates, tetramethylolmethane tetra(meth)acrylates, polypropylene glycol di(meth)acrylates (those having 2 to 14 propylene groups), dipentaerythritol penta(meth)acrylates, dipentaerythritol hexa(meth)acrylates, bisphenol A polyoxyethylene di(meth)acrylates, bisphenol A dioxyethylene di(meth)acrylates, bisphenol A trioxyethylene di(meth)acrylates and bisphenol A decaoxyethylene di(meth)acrylates); compounds obtained by adding an α,β-unsaturated carboxylic acid to a glycidyl group-containing compound (for example, trimethylolpropane triglycidyl ether triacrylate and bisphenol A diglycidyl ether diacrylate); esterification products between a polycarboxylic acid (such as phthalic anhydride) and a substance having a hydroxyl group and an ethylenically unsaturated group (such as β-hydroxyethyl (meth)acrylate); alkyl esters of acrylic acid or methacrylic acid (for example, methyl (meth)acrylate, ethyl (meth)acrylate, butyl (meth)acrylate and 2-ethylhexyl (meth)acrylate); urethane(meth)acrylates (for example, reaction products of tolylene diisocyanate and 2-hydroxyethyl (meth)acrylate and reaction products of trimethylhexamethylene diisocyanate, cyclohexane dimethanol and 2-hydroxyethyl (meth)acrylate); and substituted alkyl acrylates and substituted alkyl methacrylates in which an alkyl group of the above-described compounds is substituted with a hydroxyl group, epoxy group, halogen group or the like.

Further, examples of other vinyl compound capable of copolymerizing with an acrylic acid, methacrylic acid, alkyl acrylate or alkyl methacrylate include acrylamides, acrylonitriles, diacetone acrylamides, styrenes and vinyl toluenes. These vinyl monomers may be used individually, or two or more thereof may be used in combination.

As the vinyl compound in the present invention, it is preferred to use at least one selected from alkyl acrylates and alkyl methacrylates; and more preferably at least one selected from methyl acrylate, methyl methacrylate, ethyl acrylate and ethyl methacrylate.

In the present invention, it is preferred to use a radical polymerization initiator for polymerization of the vinyl compound. As the radical polymerization initiator, any conventionally used one may be employed without any particular restriction. Preferred examples of such radical polymerization initiator include peroxides.

As the peroxide, for example, ammonium sulfate, sodium persulfate, potassium persulfate, isobutyl peroxide, α,α'-bis(neodecanoylperoxy)diisopropylbenzene, cumylperoxy neodecanoate, di-n-propylperoxy dicarbonate, di-s-butylperoxy dicarbonate, 1,1,3,3-tetramethylbutyl neodecanoate, bis(4-t-butylcyclohexyl)peroxy dicarbonate, 1-cyclohexyl-1-methylethylperoxy neodecanoate, di-2-ethoxyethylperoxy dicarbonate, bis(ethylhexylperoxy)dicarbonate, t-hexyl neodecanoate, dimethoxybutylperoxy dicarbonate, bis(3-methyl-3-methoxybutylperoxy)dicarbonate, t-butylperoxy neodecanoate, t-hexyl peroxypivalate, 3,5,5-trimethylhexanoyl peroxide, octanoyl peroxide, lauroyl peroxide, stearoyl peroxide, 1,1,3,3-tetramethylbutylperoxy-2-ethylhexanoate, succinic peroxide, 2,5-dimethyl-2,5-di(2-ethylhexanoyl)hexane, 1-cyclohexyl-1-methylethylperoxy-2-ethylhexanoate, t-hexylperoxy-2-ethylhexanoate, 4-methylbenzoyl peroxide, t-butylperoxy-2-ethylhexanoate, m-toluoylbenzoyl peroxide, benzoyl peroxide, t-butylperoxy isobutyrate, 1,1-bis(t-butylperoxy)2-methyl cyclohexane, 1,1-bis(t-hexylperoxy)-3,3,5-trimethyl cyclohexane, 1, 1-bis(t-hexylperoxy)cyclohexane, 1,1-bis(t-butylperoxy)-3,3,5-trimethyl cyclohexane, 1,1-bis(t-butylperoxy)cyclohexanone, 2,2-bis(4,4-dibutylperoxycyclohexyl)propane, 1,1-bis(t-butylperoxy)cyclododecane, t-hexylperoxyisopropyl monocarbonate, t-butylperoxy maleic acid, t-butylperoxy-3,5,5-trimethylhexanoate, t-butylperoxylaurate, 2,5-dimethyl-2,5-bis(m-toluoylperoxy)hexane, t-butylperoxyisopropyl monocarbonate, t-butylperoxy-2-ethylhexyl monocarbonate, t-hexylperoxy benzoate, 2,5-dimethyl-2,5-bis(benzoylperoxy)hexane, t-butylperoxy acetate, 2,2-bis(t-butylperoxy)butane, t-butylperoxy benzoate, n-butyl-4,4-bis(t-butylperoxy)valerate, di-t-butylperoxy isophthalate, α,α'-bis(t-butylperoxy)diisopropylbenzene, dicumyl peroxide, 2,5-dimethyl-2,5-bis(t-butylperoxy)hexane, t-butylcumyl peroxide, di-t-butylperoxy, p-menthane hydroperoxide, 2,5-dimethyl-2,5-bis(t-butylperoxy)hexine, diisopropylbenzene hydroperoxide, t-butyltrimethylsilyl peroxide, 1,1,3,3-tetramethylbutyl hydroperoxide, cumene hydroperoxide, t-hexyl hydroperoxide, t-butyl hydroperoxide and 2,3-dimethyl-2,3-diphenylbutane may be employed.

The amount of the radical polymerization initiator to be used may be selected as appropriate in accordance with the type of the above-described vinyl compound, the refractive index of the resin particle formed or the like, and the radical polymerization initiator is used in a conventional amount. Specifically, the radical polymerization initiator may be used in an amount of, for example, from 0.1 to 15 parts by mass, and preferably from 0.5 to 10 parts by mass, with respect to 100 parts by mass of the vinyl compound.

The fluorescent material for wavelength conversion of the present invention can be obtained by mixing the above-described fluorescent substance and vinyl compound as well as, as required, a radical polymerization initiator such as a peroxide, a chain transfer agent such as n-octanethiol and the like, dissolving or dispersing the fluorescent substance in the vinyl compound and then polymerizing the resultant. The mixing method is not particularly restricted and the mixing may be performed by, for example, stirring.

It is desired that the content of the fluorescent substance in the wavelength conversion type photovoltaic cell sealing sheet be adjusted as appropriate in accordance with the type of the fluorescent substance and the like. Generally, the content of the fluorescent substance in the wavelength conversion type photovoltaic cell sealing sheet is preferably from 0.00001 to 30 parts by mass, more preferably from 0.0005 to 20 parts by mass, and still more preferably from 0.0001 to 10 parts by mass, with respect to 100 parts by mass of the above-described dispersion medium resin. At a fluorescent material content of not less than 0.0001 parts by mass, a more satisfactory wavelength conversion efficiency may be attained and at a fluorescent material content of not higher than 10 parts by mass, a reduction in the amount of light reaching the photovoltaic cell may be better prevented.

### (Ultraviolet absorber)

Further, in the wavelength conversion type photovoltaic cell sealing sheet according to the present invention, the content of an ultraviolet absorber other than the above-described fluorescent substance (hereinafter, may be simply referred to as "ultraviolet absorber") is 0.15 parts by mass or less with respect to 100 parts by mass of the above-described dispersion medium resin. By controlling the ultraviolet absorber content at 0.15 parts by mass or less, the luminous efficiency of a photovoltaic cell module may be improved.

The term "ultraviolet absorber" used herein refers to an ultraviolet absorber having an absorption wavelength peak at from 300 to 450 nm other than the above-described fluorescent substance. Further, "a content of 0.15 parts by mass or less with respect to 100 parts by mass of the dispersion medium resin" encompasses those cases where no ultraviolet absorber is contained.

The content of an ultraviolet absorber in the wavelength conversion type photovoltaic cell sealing sheet is not higher than 0.15 parts by mass, and more preferably not higher than 0.1 parts by mass, with respect to 100 parts by mass of the dispersion medium resin, and it is still more preferred that substantially no ultraviolet absorber be contained.

### (Dispersion medium resin)

The wavelength conversion type photovoltaic cell sealing sheet according to the present invention contains a dispersion medium resin which disperses the above-described fluorescent substance or the above-described fluorescent material for wavelength conversion. Specific examples of the dispersion medium resin include acrylic resins, polycarbonate resins, polystyrene resins, polyolefin resins, polyvinyl chloride resins, polyethersulfone resins, polyarylate resins, polyvinyl acetal-based resins, epoxy resins, silicone resins, fluorine resins and copolymers of these resins.
The above-described dispersion medium resins may be used individually, or two or more thereof may be used in combination.

Examples of the above-described acrylic resins include (meth)acrylate resins. Examples of the polyolefin resins include polyethylenes and polypropylenes. Examples of the polyvinyl acetal-based resins include polyvinyl formal, polyvinyl butyral (PVB resin) and modified PVB.

Further, the term "(meth)acrylate resin" means a resin which has a structural unit derived from acrylic ester or (meth)acrylic ester, and examples of alkyl acrylate and alkyl methacrylate include unsubstituted alkyl acrylates and unsubstituted alkyl methacrylates such as methyl acrylate, methyl methacrylate, ethyl acrylate, ethyl methacrylate, butyl acrylate, butyl methacrylate, 2-ethylhexyl acrylate and 2-ethylhexyl methacrylate; and substituted alkyl acrylates and substituted alkyl methacrylates in which an alkyl groups of the above-described compounds is substituted with a hydroxyl group, epoxy group, halogen group or the like.

The acrylic ester or (meth)acrylic ester is preferably an alkyl ester having from 1 to 10 carbon atoms, more preferably an alkyl ester having from 2 to 8 carbon atoms, of acrylic acid or methacrylic acid.
Specific examples of the acrylic ester or (meth)acrylic ester include ethyl methacrylate, butyl methacrylate, 2-ethylhexyl methacrylate, 2-hydroxyethyl methacrylate, cyclohexyl methacrylate, phenyl methacrylate, benzyl methacrylate, methyl acrylate, ethyl acrylate, butyl acrylate, 2-ethylhexyl acrylate, 2-hydroxyethyl acrylate, cyclohexyl acrylate, phenyl acrylate and benzyl acrylate.

The (meth)acrylate resin may also be made into a copolymer using, in addition to acrylic ester or (meth)acrylic ester, an unsaturated monomer capable of copolymerizing therewith.

Examples of the above-described unsaturated monomer include unsaturated acids such as methacrylic acid and acrylic acid, styrenes, α-methylstyrenes, acrylamides, diacetone acrylamides, acrylonitriles, methacrylonitriles, maleic anhydrides, phenylmaleimide and cyclohexylmaleimides and, as required, two or more of these may be used as well.
These unsaturated monomers may be used individually, or two or more thereof may be used in combination.

Thereamong, as the (meth)acrylate resin, those having a structural unit derived from methyl acrylate, ethyl acrylate, isobutyl acrylate, n-butyl acrylate, 2-ethylhexyl acrylate, methyl methacrylate or n-butyl methacrylate are preferred, and from the viewpoint of the durability and versatility, those having a structural unit derived from methyl methacrylate are more preferred.
Examples of the copolymer resin include (meth)acrylate-styrene copolymers and ethylene-vinyl acetate copolymers (hereinafter, abbreviated as "EVA").

From the viewpoint of the moisture resistance, cost and versatility, EVAs are preferred, and from the viewpoint of the durability and surface hardness, (meth)acrylate resins are preferred. Further, it is more preferable to use an EVA and (meth)acrylate resin in combination from the standpoint of combining their advantages.

As for the EVA, taking the total amount of the EVA as 100 parts by mass, the content of vinyl acetate unit is preferably from 10 to 50 parts by mass, and from the standpoint of the uniform dispersion of a rare earth complex to a sealing material, the content is preferably from 20 to 35 parts by mass.

As an EVA resin containing no ultraviolet absorber, a commercially available product may be appropriately employed, and examples thereof include ULTRATHENE 634 manufactured by Tosoh Corporation, EVAFLEX manufactured by Du Pont-Mitsui Polychemicals Co., Ltd., SUNTEC EVA manufactured by Asahi Kasei Chemicals Corporation, UBE EVA copolymers manufactured by Ube-Maruzen Polyethylene Co. Ltd., EVATATE manufactured by Sumitomo Chemical Co., Ltd. and NOVATEC EVA manufactured by Japan Polyethylene Corporation.

It is noted here that SOLAR EVA manufactured by Mitsui Chemical Fabro Inc., which is an ethylene-vinyl acetate copolymer resin (EVA) photovoltaic cell sealing material, is estimated to contain an ultraviolet absorber in an amount of 0.25 parts by mass with respect to 100 parts by mass of the resin and that EVA SAFE manufactured by Bridgestone Corporation, which is an EVA resin sealing material, is estimated to contain an ultraviolet absorber in an amount of 0.21 parts by mass with respect to 100 parts by mass of the resin.

In cases where an EVA and methyl methacrylate are used in combination, the EVA content is preferably not less than 50 parts by mass, and preferably not less than 70 parts by mass, with respect to 100 parts by mass of the total amount of the EVA and methyl methacrylate.

Further, the above-described dispersion medium resin may also be allowed to have a cross-linked structure by adding thereto a cross-linkable monomer.
Examples of the cross-linkable monomer include: dicyclopentenyl (meth)acrylates; tetrahydrofurfuryl (meth)acrylates; benzyl (meth)acrylates; compounds obtained by a reaction between a polyhydric alcohol and an α,β-unsaturated carboxylic acid (for example, polyethylene glycol di(meth)acrylates (those having 2 to 14 ethylene groups), trimethylolpropane di(meth)acrylates, trimethylolpropane tri(meth)acrylates, trimethylolpropane ethoxy tri(meth)acrylates, trimethylolpropane propoxy tri(meth)acrylates, tetramethylolmethane tri(meth)acrylates, tetramethylolmethane tetra(meth)acrylates, polypropylene glycol di(meth)acrylates (those having 2 to 14 propylene groups), dipentaerythritol penta(meth)acrylates, dipentaerythritol hexa(meth)acrylates, bisphenol A polyoxyethylene di(meth)acrylates, bisphenol A dioxyethylene di(meth)acrylates, bisphenol A trioxyethylene di(meth)acrylates and bisphenol A decaoxyethylene di(meth)acrylates); compounds obtained by adding an α,β-unsaturated carboxylic acid to a glycidyl group-containing compound (for example, trimethylolpropane triglycidyl ether triacrylate and bisphenol A diglycidyl ether diacrylate); esterification products between a polycarboxylic acid (such as phthalic anhydride) and a substance having a hydroxyl group and an ethylenically unsaturated group (such as β-hydroxyethyl (meth)acrylate); alkyl esters of acrylic acid or methacrylic acid (for example, methyl (meth)acrylate, ethyl (meth)acrylate, butyl (meth)acrylate and 2-ethylhexyl (meth)acrylate); and urethane(meth)acrylates (for example, reaction products of tolylene diisocyanate and 2-hydroxyethyl (meth)acrylate and reaction products of trimethylhexamethylene diisocyanate, cyclohexane dimethanol and 2-hydroxyethyl (meth)acrylate).

Examples of particularly preferred cross-linkable monomer include trimethylolpropane tri(meth)acrylates, dipentaerythritol tetra(meth)acrylates, dipentaerythritol hexa(meth)acrylates and bisphenol A polyoxyethylene di(meth)acrylates.
It is noted here that the above-described cross-linkable monomers are used individually, or two or more thereof are used in combination.

Alternatively, the above-described resin may be made to have a cross-linked structure by adding a thermal polymerization initiator or a photopolymerization initiator to the above-described monomer and heating or irradiating a light to polymerize the monomer.

Examples of the thermal polymerization initiator include 2,5-dimethylhexane-2,5-dihydro peroxide, 2,5-dimethyl-2,5-di(t-butylperoxy)hexane-3, di-t-butyl peroxide, dicumyl peroxide, 2,5-dimethyl-2,5-di(t-butylperoxy)hexane, dicumyl peroxide, α,α'-bis(t-butylperoxyisopropyl)benzene, n-butyl-4,4-bis(t-butylperoxy)butane, 2,2-bis(t-butylperoxy)butane, 1,1-bis(t-butylperoxy)cyclohexane, 1,1-bis(t-butylperoxy)3,3,5-trimethyl cyclohexane, t-butylperoxy benzoate and benzoyl peroxide.
The content of the thermal polymerization initiator is sufficient at 5 parts by mass with respect to the dispersion medium resin.

As the photopolymerization initiator, a photoinitiator which forms a free radical when irradiated with ultraviolet radiation or visible light is preferred, and examples thereof include benzoin ethers such as benzoin methyl ether, benzoin ethyl ether, benzoin propyl ether, benzoin isobutyl ether and benzoin phenyl ether; benzophenones such as benzophenone, N,N'-tetramethyl-4,4'-diaminobenzophenone (Michler's ketone) and N,N'-tetraethyl-4,4'-diaminobenzophenone; benzyl ketals such as benzyl dimethyl ketal (manufactured by Ciba Japan Chemicals K.K.; IRGACURE 651) and benzyl diethyl ketal; acetophenones such as 2,2-dimethoxy-2-phenylacetophenone, p-tert-butyldichloroacetophenone and p-dimethylaminoacetophenone; xanthones such as 2,4-dimethylthioxanthone and 2,4-diisopropylthioxanthone; hydroxycyclohexyl phenyl ketone (manufactured by Ciba Specialty Chemicals K.K.; IRGACURE 184); 1-(4-isopropylphenyl)-2-hydroxy-2-methylpropane-1-one (manufactured by Ciba Japan Chemicals K.K.; DAROCURE 1116); and 2-hydroxy-2-methyl-1-phenylpropane-1-one (manufactured by Merk Co. Ltd.; DAROCURE 1173). These photoinitiators are used individually, or two or more thereof are used in combination.

Further, examples of photoinitiator which may be used as a photopolymerization initiator include combinations of 2,4,5-triarylimidazole dimer with 2-mercaptobenzoxazole, leuco crystal violet, tris(4-diethylamino-2-methylphenyl)methane or the like. In addition, such an additive that does not itself have photoinitiating characteristics but, when combined with the above-described substances, functions as a sensitizer system having a higher photoinitiating performance as a whole, for example, a tertiary amine for benzophenone such as triethanolamine, may also be used.
The content of the photopolymerization initiator is sufficient at 5 parts by mass with respect to the dispersion medium resin.

From the viewpoint of the coating film properties, coating film strength and the like, the weight average molecular weight of the above-described dispersion medium resin is preferably from 10,000 to 300,000.

In addition to the above-described additive, the wavelength conversion type photovoltaic cell sealing sheet according to the present invention may also contain, as required, a coupling agent, plasticizer, flame retardant, antioxidant, light stabilizer, corrosion inhibitor, processing aid, colorant and the like.

### (Wavelength conversion type photovoltaic cell sealing sheet)

The wavelength conversion type photovoltaic cell sealing sheet according to the present invention can be produced by a known technique. For instance, a method in which at least the above-described fluorescent substance and dispersion medium resin and, as required, other additive(s) are melt-kneaded and molded into a sheet, or a method in which, after making the above-described resin into a varnish and adding thereto the fluorescent substance, the resultant is provided in the form of a sheet and the solvent is then removed may be employed.
Specifically, for example, a sheet can be formed by arranging two mold-releasing sheets to face each other via a spacer, providing the above-described melt-kneaded composition into the gap formed between the two mold-releasing sheets and then heat-pressing the resultant from both sides.

The thickness of the wavelength conversion type photovoltaic cell sealing sheet is preferably from 10 µm to 1,000 µm, and more preferably from 400 µm to 600 µm.

The wavelength conversion type photovoltaic cell sealing sheet according to the present invention is constituted in such a manner to reduce a loss of sunlight caused by spectral mismatch and convert a light in the ultraviolet region to a light in a high sensitive wavelength region, so that a high light utilization efficiency may be attained and the power generation efficiency may be improved. Further, the wavelength conversion type photovoltaic cell sealing sheet according to the present invention also functions as an ultraviolet absorber because of the fluorescent substance particle and exhibits comparable anti-weatherability to an EVA resin containing an ultraviolet absorber other than a fluorescent substance (such as trade name: SOLAR EVA manufactured by Mitsui Chemical Fabro Inc.).

### <Photovoltaic cell module>

The photovoltaic cell module according to the present invention has at least a photovoltaic cell and the above-described wavelength conversion type photovoltaic cell sealing sheet provided on the light-receiving surface side of this photovoltaic cell. Fig. 1 is a schematic cross-sectional view showing an example of the photovoltaic cell module.
The photovoltaic cell module of Fig. 1 has a protective layer 12 on the light-receiving surface side of a photovoltaic cell 10 and a back film 14 on the back surface side. Further, a sealing layer 16 is provided between the protective layer 12 and the photovoltaic cell 10, and the above-described wavelength conversion type photovoltaic cell sealing sheet is used as this sealing layer 16. In addition, a back-surface sealing layer 18 is provided between the back film 14 and the photovoltaic cell 10. The back-surface sealing layer 18 is not particularly restricted as long as it can seal the photovoltaic cell 10 and for example, it is also possible to apply the above-described wavelength conversion type photovoltaic cell sealing sheet not containing the above-described fluorescent substance.

Further, although not shown in Fig. 1, the photovoltaic cell module according to the present invention may also have a member which is normally provided in a photovoltaic cell module, such as an anti-reflection film.

In the photovoltaic cell module according to the present invention, since the above-described wavelength conversion type photovoltaic cell sealing sheet is provided on the light-receiving surface side, the power generation efficiency may be improved while preventing a reduction in the anti-weatherability.

The disclosure of Japanese Patent Application No. 2010-076313 is hereby incorporated by reference in its entirety.
All publications, patent applications, and technical standards mentioned in this specification are herein incorporated by reference to the same extent as if each individual publication, patent application, or technical standard was specifically and individually indicated to be incorporated by reference.

### EXAMPLES

The present invention will now be described in more detail by way of examples thereof; however, the present invention is not restricted to these examples.

### [Example 1]

### (Synthesis of fluorescent substance particle)

First, a fluorescent substance was synthesized. To 7 ml of ethanol, 200 mg of 4,4,4-trifluoro-1-(thienyl)-1,3-butanedione (TTA) was dissolved and 1.1 ml of 1M sodium hydroxide was added thereto and the resultant was mixed. After adding 6.2 mg of 1,10-phenanthroline dissolved in 7 ml of ethanol to the thus obtained mixed solution and stirring the resultant for 1 hour, 3.5 ml of an aqueous solution containing 103 mg of EuCl₃-6H₂O was further added to obtain a precipitate. This precipitate was removed by filtration, washed with ethanol and dried to obtain a fluorescent substance, Eu(TTA)₃Phen.

### (Preparation of resin composition for wavelength conversion)

A monomer mixture was prepared by mixing and stirring 0.3 parts by mass of Eu(TTA)₃Phen, which was obtained in the above as a fluorescent substance, 60 parts by mass of methyl methacrylate as a vinyl compound and 0.012 parts by mass of n-octanethiol as a chain transfer agent. Further, 3.65 parts by mass of sodium alkyl benzene sulfonate (G-15, manufactured by KAO Corporation) was added as a surfactant to 300 parts by mass of ion-exchanged water and to the resultant, and the above-described monomer mixture was added to the resultant to obtain a resulting mixture. In a flask having a reflux condenser, the resulting mixture was maintained at 60°C with stirring under nitrogen flow and 0.03 parts by mass of potassium persulfate was added thereto as a radical polymerization initiator. The resultant was subjected to emulsion polymerization for 4 hours and at the end of this process, the temperature was raised to 90°C to complete the polymerization reaction. The resulting fluorescent material for wavelength conversion was in the form of particles having a primary particle diameter of about 100 nm. After appropriately subjecting the fluorescent material for wavelength conversion to a post-treatment with isopropyl alcohol or the like, the resultant was removed by filtration, dried and sieved as appropriate to obtain a particulate fluorescent material for wavelength conversion.

### (Preparation of resin composition for wavelength conversion)

Using a roll mill at 90°C, 100 g of an ethylene-vinyl acetate resin (EVA) manufactured by Tosoh Corporation: ULTRATHENE 634 (containing no ultraviolet absorber) as a transparent dispersion medium resin, 1.5 g of a peroxide thermal radical polymerization initiator manufactured by Arekema Yoshitomi, Ltd.: LUPEROX 101 (in the present Example, also functioning as a cross-linking agent), 0.5 g of a silane coupling agent manufactured by Dow Corning Toray Co., Ltd.: SZ6030 and 2 g of the particulate fluorescent material for wavelength conversion obtained in the above were kneaded to obtain a resin composition for wavelength conversion.

### (Production of wavelength conversion type photovoltaic cell sealing sheet)

About 30 g of the thus obtained resin composition for wavelength conversion was sandwiched by mold-releasing sheets and made into the form of a sheet using a 0.6 mm-thick stainless steel spacer and a press having a heating plate adjusted to 80°C, thereby obtaining a wavelength conversion type photovoltaic cell sealing sheet. This wavelength conversion type photovoltaic cell sealing sheet contains no ultraviolet absorber.

### (Production of back-surface photovoltaic cell sealing sheet)

A back-surface photovoltaic cell sealing sheet was produced in the same manner as in the case of the above-described wavelength conversion type photovoltaic cell sealing sheet, except that the fluorescent material for wavelength conversion was not added.

### (Production of photovoltaic cell module)

The above-described wavelength conversion type photovoltaic cell sealing sheet was placed on a tempered glass (manufactured by Asahi Glass Co., Ltd.) used as a protective glass, and thereon sequentially placed were a photovoltaic cell from which an electromotive force can be taken out to outside, the back-surface photovoltaic cell sealing sheet and a PET film (manufactured by Toyobo Co., Ltd.; trade name: A-4300) used as a back film. The resultant was laminated using a vacuum laminator to produce a photovoltaic cell module of Example 1.

### [Comparative Example 1]

### (Production of photovoltaic cell module containing ultraviolet absorber)

A tempered glass (manufactured by Asahi Glass Co., Ltd.) as a protective glass, an ethylene-vinyl acetate copolymer resin (EVA) photovoltaic cell sealing material (manufactured by Mitsui Chemical Fabro Inc., trade name: SOLAR EVA; presumed to contain 0.25 parts by mass of an ultraviolet absorber, 0.04 parts by mass of a light stabilizer, 0.4 parts by mass of a cross-linking aid and 0.5 parts by mass of a silane coupling agent) as a sealing material, a photovoltaic cell (with the light-receiving surface facing down), the above-described EVA resin (0.6 mm in thickness) and a polyethylene terephthalate (PET) film (manufactured by Toyobo Co., Ltd., A-4300) as a back film were laminated in this order using a vacuum laminator to produce a photovoltaic cell module of Comparative Example 1.

### [Comparative Example 2]

### (Production of photovoltaic cell module containing no fluorescent substance)

A tempered glass (manufactured by Asahi Glass Co., Ltd.) as a protective glass, the back-surface photovoltaic cell sealing sheet of Example 1 as a sealing material, a photovoltaic cell (with the light-receiving surface facing down), the above-described back-surface photovoltaic cell sealing sheet and a polyethylene terephthalate (PET) film (manufactured by Toyobo Co., Ltd., A-4300) as a back film were laminated in this order using a vacuum laminator to produce a photovoltaic cell module of Comparative Example 2.

### <Evaluation of photovoltaic cell properties>

Using a solar simulator (manufactured by Wacom Electric Co., Ltd.; WXS-155S-10, AM1.5G) to generate a simulated sunlight and an I-V curve tracer (manufactured by EKO Instruments Co., Ltd.; MP-160), the current-voltage characteristics were evaluated by measuring the conditions of each cell before and after sealing the module and taking the difference thereof.
It is noted here that those values of Jsc (short-circuit current density), Isc (short-circuit current), Voc (open-circuit voltage), Pm (maximum output), Ipm (maximum output operating current), Vpm (maximum output operating voltage), F.F. (fill factor) and ηᵢₙ (photovoltaic cell module conversion efficiency) that indicate the power generation performance of a photovoltaic cell were obtained by performing measurements in accordance with JIS-C-8913 and JIS-C-8914.
Table 1 below shows the measurement results for the photovoltaic cell modules of Example 1 and Comparative Example 1.

**[Table 1]**

| | | Jsc [mA/cm²] | Isc [mA] | Voc [mV] | Pm [mW] | Ipm [mA] | Vpm [mV] | F.F. | ηᵢₙ [%] |
|---|---|---|---|---|---|---|---|---|---|
| Example 1 | Cell | 30.97 | 6968 | 609.4 | 2765 | 6118 | 451.9 | 0.651 | 12.29 |
| | Module | 31.57 | 7104 | 609.8 | 2892 | 6371 | 453.9 | 0.667 | 12.85 |
| | Difference | 0.60 | 136 | 0.4 | 127 | 252 | 2.0 | 0.016 | 0.56 |
| Comparative Example 1 | Cell | 31.81 | 7157 | 588.8 | 2773 | 6411 | 432.5 | 0.658 | 12.32 |
| | Module | 31.84 | 7165 | 585.6 | 2767 | 6418 | 431.2 | 0.659 | 12.30 |
| | Difference | 0.03 | 8 | -3.2 | -6 | 7 | -1.3 | 0.001 | -0.02 |

As shown in Table 1, the conversion efficiency ηᵢₙ (%) was -0.02% in Comparative Example 1, while it was 0.56% in Example 1. Therefore, it is understood that the module of Example 1 has an improved conversion efficiency as compared to that of Comparative Example 1.

### <Evaluation of anti-weatherability of photovoltaic cell modules>

For the above-described photovoltaic cell modules of Example 1 and Comparative Examples 1 and 2, using a high-energy xenon weather meter (manufactured by Suga Test Instruments Co., Ltd.; XEL-1WN) and an I-V curve tracer (manufactured by EKO Instruments Co., Ltd.; MP-160), the anti-weatherability was evaluated by measuring and comparing the F.F. (fill factor) values before exposure to light and 168 hours and 336 hours after exposure to light.
The measurement results are shown in Table 2.

**[Table 2]**

| | F.F. | | | Decrease after 336 hours (%) |
|---|---|---|---|---|
| | 0 hour | 168 hours | 336 hours | |
| Example 1 | 0.6726 | 0.6695 | 0.6700 | 0.39 |
| Comparative Example 1 | 0.6707 | 0.6537 | 0.6693 | 0.21 |
| Comparative Example 2 | 0.6644 | 0.6636 | 0.6192 | 6.8 |

As shown in Table 2, while the decrease in F.F. after 336 hours was 6.8% in Comparative Example 2, it was not greater than 0.5% in Example 1 and Comparative Example 1. Here, as described in the above, the conversion efficiency ηᵢₙ (%) of Comparative Example 1 was largely inferior to that of Example 1.

## Claims

1. A wavelength conversion type photovoltaic cell sealing sheet comprising a dispersion medium resin and a fluorescent material having an absorption wavelength peak at from 300 to 450 nm, wherein a content of an ultraviolet absorber other than the fluorescent material is 0.15 parts by mass or less with respect to 100 parts by mass of the dispersion medium resin.

2. A wavelength conversion type photovoltaic cell sealing sheet according to claim 1, wherein the fluorescent substance is a europium complex.

3. A photovoltaic cell module comprising a photovoltaic cell and the wavelength conversion type photovoltaic cell sealing sheet according to claim 1 or 2 provided on a light-receiving surface side of said photovoltaic cell.
